# EUROPEAN PATENT SPECIFICATION

(11) **EP 2 294 694 B1**
(45) Date of publication and mention of the grant of the patent: **16.05.2018**
(21) Application number: 09765514.6
(22) Date of filing: 27.05.2009
(51) Int. Cl.: H03K 17/96

(54) **INPUT DEVICE**
EINGABEVORRICHTUNG
DISPOSITIF D'ENTRÉE

(30) Priority: 30.05.2008 EP 08009922
(43) Date of publication of application: 16.03.2011
(73) Proprietor: Electrolux Home Products Corporation N.V., 1130 Brussels (BE)
(72) Inventor: JEANNETEAU, Laurent, F-60200 Compiègne (FR); RIGOLLE, Thibaut, I-47100 Forli (IT); NOSTRO, Massimo, 47100 Forli (IT); GRASSANO, Andrea, I-47122 Forli (IT)
(74) Representative: Electrolux Group Patents
(86) International application number: PCT/EP2009/003772
(87) International publication number: WO 2009/152934

(56) References cited:
- WO-A2-2008/005505
- US-A1- 2005 088 416
- US-A1- 2007 198 141
- US-B1- 6 452 514

## Description

The invention relates to an input device for a home appliance for operation with a finger according to the preamble of claim 1. Further, the invention relates to a method for data input for a home appliance for operation with a finger according to the preamble of claim 8.

For home appliances, keys or switches are known for operating the appliance with a finger. However, single keys or switches are not able to detect a two dimensional position of a finger or a movement of a finger.

WO 2008/005505 A2 discloses a touch sensing device. The touch sensing device includes multifunctional nodes each of which represents a single touch pixel. Each multifunctional node includes a touch sensor with one or more integrated input-output mechanisms. The touch sensor and integrated input-output mechanisms share the same communication lines of a controller during operation of the touch sensing device. The touch sensors are configured to activate as the finger performs an action over them. In the simplest case, an electrical signal is produced each time the finger passes the touch sensor. The number of signals in a given time frame may indicate location, direction, speed and acceleration of the finger on the touch pad. The number of signals depends on the number of actions by the finger of the user. Thus, the controller has to process a lot of signals in the most cases.

Therefore, it is an object of the invention, to propose an improved input device, which requires a reduced number of signals.

This object is solved by an input device according to claim 1 and a method for data input according to claim 8. Advantageous embodiments are described particularly in the dependent claims.

According to claim 1, the acceleration of the finger movement is detectable by comparing at least three succeeding or successive or subsequent positions of the finger, wherein the distance between the first and the second measurement is compared with the distance between the second and the third measurement.

The input device according to the invention allows the detection of a two dimensional position of a finger on a surface, as well as the detection of an acceleration of the movement of the finger. The input device can be operated by small fingers as well as by large fingers with the same result. The detection is possible with an at least relatively good resolution.

Preferably, the detection of the position is repeatable after a predefined time span, especially 100 ms, and/or a movement of the finger is detectable, preferably based on a fixed and/or an arbitrary starting point.

In an advantageous embodiment, the keys are at least substantially circular. As an alternative, keys which are at least substantially rectangular or with another form are possible.

Preferably, the position of the finger is detectable by the comparing the generated key voltages and determining the largest key voltage. This eases it to refer to relative voltages or values which are independent from the size of a finger.

In an advantageous embodiment, an acceleration of the finger movement is detectable, by comparing three succeeding positions of the finger. By this, additional information can be submitted by a movement of the finger.

Preferably, the input device is integrated into a cooking device, particularly a, preferably transparent, glass of a cooking hob, especially a glass ceramic stove top, and/or an induction hob and/or a cooking oven and/or a steamer and/or a micro wave oven and/or a micro wave oven combi and/or a freestanding cooking device and/or a combi oven cook top. This makes it possible to implement a lot of functionality into the cooking device where, on the other side, no or at least only little additional space is required as the existing glass surface can be used.

In an advantageous embodiment, the position of the finger is displayed on a display and/or a screen, preferably by a cursor. This gives the operator a good feedback of his actions.

According to claim 8, the acceleration of the finger movement is detected by comparing at least three succeeding or successive or subsequent positions of the finger, wherein the distance between the first and the second measurement is compared with the distance between the second and the third measurement.

Preferably, the position of the finger is detected by determining the largest key voltage.

In an advantageous embodiment, an acceleration of the finger movement is detected by comparing three or at least three, especially succeeding, detected positions of the finger.

The invention will be now described in further details with references to the figures, in which
FIG 1 shows an input device according to the invention,
FIG 2 shows, as a detail, four sensitive keys with equivoltage lines,
FIG 3 shows a block diagram of an input device according to the invention and in which
FIG 4 shows an input device according to the invention integrated into an induction cooking hob.

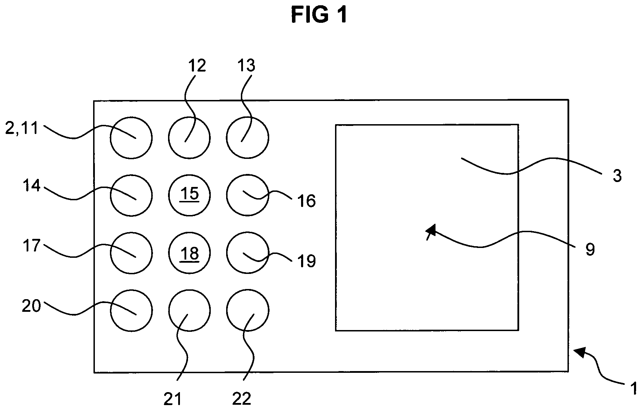

FIG 1 shows an input device 1 according to the invention, with a two-dimensional array 2 of sensitive keys 11 to 22 and a display 3 arranged beside the two-dimensional key array or matrix 2.

FIG 1 shows a matrix 2 of three rows and four columns (3 X 4) of keys 11 to 22, which are arranged in a rectangular form.

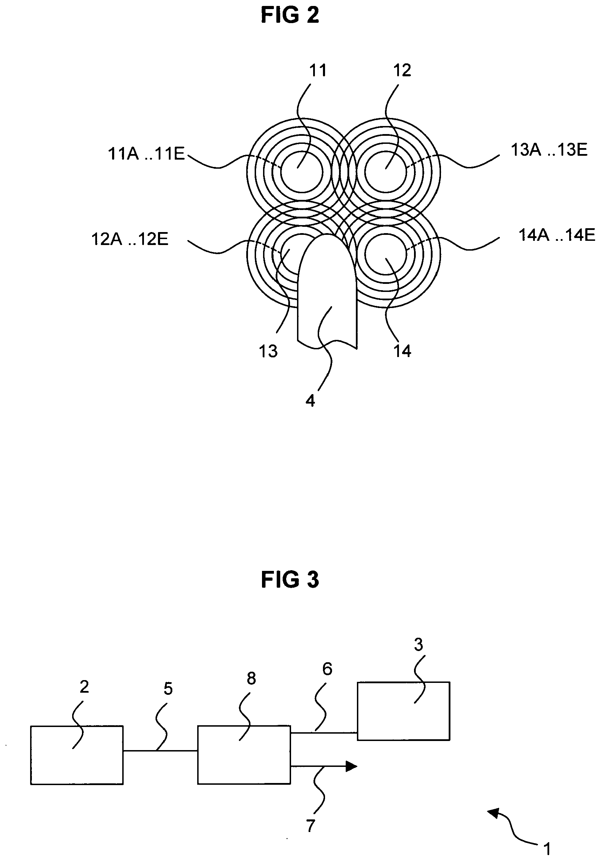

When the finger approaches to a sensitive key, a voltage is generated depending on the distance from the key. The generated voltages are then compared in a detection unit shown in FIG 3, where the highest voltage value defines the position of the finger 4 in the two dimensional array 2.

The input device 1 works similar like a mouse pad and moves an index on the display or screen 3 to select a different function.

The sensitive keys 11 to 22 are preferably implemented as capacitive keys. The capacitive areas of the keys 11 to 22 are arranged side by side in a non-overlapping manner. This makes it possible to locate the position relative to the finger 4 with at least substantially good accuracy.

The keys 11 to 22 are at least substantially circular. As an alternative, the keys can also have another form.

For the input device 1, a fix center key can be defined, which is preferably in or near the center of the two-dimensional array 2, for example key 15. Relative to this key 15, a left, top, right and a bottom region are defined.

In this example, key 14 is in the left region, key 12 is in the top region, key 16 is in the right region and key 18 is in the bottom region. If the finger touches one of these keys, the cursor 9 on the display 3 will move into the corresponding direction.

The voltages are repeatedly generated and measured in predefined time spans, so that, by comparison of two succeeding detected values, the detection of the movement of the finger is also possible. A cursor 9 on the display 3 is moved in the detected direction. The detection of the movement can therefore also be executed based on an arbitrary starting point.

Also, the detection of an acceleration of the finger movement is possible. To detect the acceleration, at least three voltage values are compared. The values can be succeeding values with the same time difference. As an alternative, also values which have different time differences and/or which are not succeeding values can be compared. In case three voltage values are compared, the distance between the first and the second measurement is compared with the distance between the second and the third measurement.

Different finger sizes can generate different voltages in the sensitive keys. However, since the generated voltages are compared with each other, only the relative values of the sensitive keys are relevant.

For the array, different sizes are possible. Examples are 2 X 3, 3 X 3, 3 X 4, 4 X 4, or any other combination.

FIG 2 shows schematically which voltages are generated by the touch with the finger 4. The voltages generated by the sensitive keys 11 to 14 depend on the distance from the sensitive keys 11 to 14. Points where the same voltage is generated are arranged along circles around the sensitive key. FIG 2 shows such equivoltage lines 11A to 11E, 12A to 12E, 13A to 13E as well as 14A to 14E, which are generated depending on the distance of the finger 4 from the sensitive keys 11 to 14.

As an alternative, equivoltage lines can proceed along squares or rectangles or in other form around the sensitive keys, depending on the form of the keys.

FIG 3 shows a block diagram of the input device 1, with the key array 2 generating the voltage values of the keys, a detection unit 8 connected with the key array 2 by connection lines 5 detecting the closest sensitive key and the movement and/or the acceleration of the finger. The detected values are, on the one hand, passed via connection lines 6 to the display 3 and, on the other hand, passed to a further unit for further processing via connection lines 7.

According to a first example with a finger size of 7 mm, a voltage U13 is generated by key 13 with 350 mV, a voltage U14 is generated by key 14 with 120 mV and a voltage U11 is generated by key 11 with 50 mV. It will be detected, that the finger is on key 13 and close to key 14.

If the input device 1 is operated by a finger 4 with a diameter of 12 mm, a voltage U13 will be generated by key 13 with 400 mV, a voltage U14 will be generated by key 14 with 150 mV and a voltage U11 will be generated by key 11 with 70 mV. All voltage values are higher compared to the values generated by the finger with a size of 7 mm. But as the evaluation and detection is done by comparison, the result will be exactly the same. Also in this case, the finger on key 13 and close to key 14 will be detected. The measurements are taken every 100 ms.

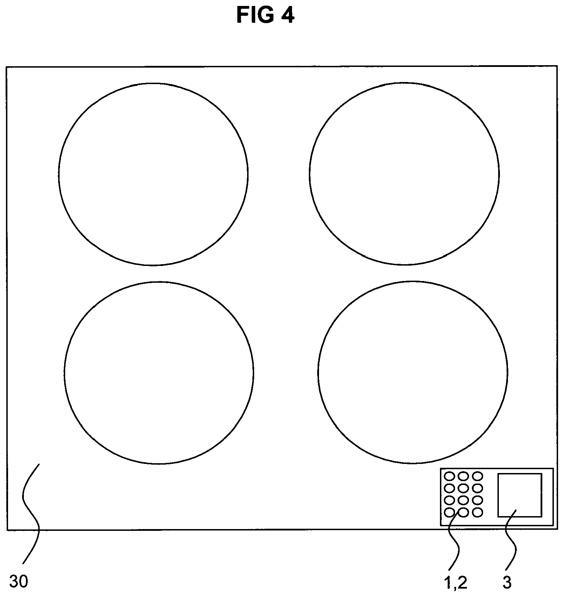

FIG 4 shows an input device 1 according to the invention integrated into an induction cooking hob 30. The induction cooking hob 30 comprises a transparent glass surface with back coating or enamelling. The input device 1 is arranged below the surface of the glass of the induction cooking hob 30. The sensitive keys in the key array 2 of the input device 1 can be operated from above the surface of the induction cooking hob 30.

As an alternative, the input device can also be integrated into any other cooking hob, especially with transparent glass or outside the glass of a cooking hob.

### List of reference signs

- 1: input device
- 2: key array
- 3: display
- 4: finger
- 5 - 7: connection lines
- 8: detection unit
- 9: cursor
- 11 - 22: keys
- 11A - 11E, 12A - 12E, 13A - 13E, 14A - 14E: equivoltage lines
- 30: induction hob

## Claims

1. Input device (1) for a home appliance for operation with a finger (4), comprising
a) sensitive keys (11 - 22) arranged below a surface in a two-dimensional array (2),
b) wherein a key voltage based on the nearness of the finger (4) is generatable by each sensitive key (11 - 22) dependant on the distance from the key and the size of the finger (4),
c) wherein in a detection unit (8) all key voltages are comparable,
d) wherein in the detection unit (8) the position of the finger (4) is detectable and
e) wherein an acceleration of the finger movement is detectable by comparing positions of the finger,
**characterized in that**
the acceleration of the finger movement is detectable by comparing at least three succeeding or successive or subsequent positions of the finger, wherein the distance between the first and the second measurement is compared with the distance between the second and the third measurement.

2. Input device according to claim 1,
a) wherein the detection of the position is repeatable after a predefined time span, especially 100 ms, and/or
b) wherein a movement of the finger (4) is detectable, preferably based on a fixed and/or an arbitrary starting point.

3. Input device according to claim 1 or 2, wherein the sensitive keys are at least substantially circular.

4. Input device according to one of the preceding claims, wherein the position of the finger is detectable by comparing the generated key voltages and determining the largest key voltage.

5. Input device according to one of the preceding claims, wherein an acceleration of the finger movement is detectable by comparing three succeeding or successive or subsequent, positions of the finger.

6. Input device according to one of the preceding claims, wherein the input device is integrated into a cooking device, particularly a, preferably transparent, glass of a cooking hob, especially a glass ceramic stove top, and/or an induction hob and/or a cooking oven and/or a steamer and/or a micro wave oven and/or a micro wave oven combi and/or a freestanding cooking device and/or a combi oven cook top.

7. Input device according to one of the preceding claims, wherein the position of the finger (4) is displayed on a display (3), preferably by a cursor (9).

8. Method for data input for a home appliance for operation with a finger (4), especially for an input device according to one of the preceding claims,
a) with sensitive keys (11 - 22) arranged below a surface in a two-dimensional array (2),
b) wherein a key voltage is generated based on the nearness of the finger by each sensitive key (11 - 22) dependant on the distance from the key and the size of the finger (4),
c) wherein all generated key voltages are compared,
d) wherein the position of the finger is detected, and
e) wherein an acceleration of the finger movement is detected by comparing detected positions of the finger (4),
**characterized in that**
the acceleration of the finger movement is detected by comparing at least three succeeding or successive or subsequent positions of the finger, wherein the distance between the first and the second measurement is compared with the distance between the second and the third measurement.

9. Method according to claim 8, wherein the position of the finger (4) is detected by determining the largest key voltage.

10. Method according to claim 8 or 9, wherein an acceleration of the finger movement is detected by comparing three or at least three, especially succeeding, detected positions of the finger (4).

11. Method according to one of the claims 8 to 10,
wherein the detection is repeated after a predefined time span.

12. Method according to one of the claims 8 to 11, wherein a movement of the finger (4) is detected.

## Patentansprüche

1. Eingabevorrichtung (1) für ein Haushaltsgerät zur Bedienung mit einem Finger (4), umfassend:
a) sensitive Tasten (11 - 22), die unter einer Oberfläche in
einem zweidimensionalen Feld (2) angeordnet sind,
b) wobei eine Tastenspannung, die auf Nähe des Fingers (4) basiert, durch jede sensitive Taste (11-22) in Abhängigkeit vom Abstand von der Taste und der Größe des Fingers (4) erzeugt werden kann,
c) wobei in einer Detektionseinheit (8) alle Tastenspannungen verglichen werden können,
d) wobei in der Detektionseinheit (8) die Position des Fingers (4) detektiert werden kann, und
e) wobei eine Beschleunigung der Fingerbewegung durch Vergleichen von Positionen des Fingers detektiert werden kann,
**dadurch gekennzeichnet, dass**
die Beschleunigung der Fingerbewegung durch Vergleichen mindestens dreier aufeinanderfolgender oder sukzessiver oder fortlaufender Positionen des Fingers detektiert werden kann,
wobei der Abstand zwischen der ersten und der zweiten Messung mit dem Abstand zwischen der zweiten und der dritten Messung verglichen werden kann.

2. Eingabevorrichtung nach Anspruch 1,
a) wobei die Detektion der Position nach einer vordefinierten Zeitspanne, insbesondere 100 ms, wiederholt werden kann, und/oder
b) wobei eine Bewegung des Fingers (4) vorzugsweise basierend auf einem festen und/oder einem beliebigen Ausgangspunkt detektiert werden kann.

3. Eingabevorrichtung nach Anspruch 1 oder 2, wobei die sensitiven Tasten wenigstens im Wesentlichen kreisförmig sind.

4. Eingabevorrichtung nach einem der vorhergehenden Ansprüche, wobei die Position des Fingers durch Vergleichen der erzeugten Tastenspannungen und Bestimmen der größten Tastenspannung detektiert werden kann.

5. Eingabevorrichtung nach einem der vorhergehenden Ansprüche, wobei eine Beschleunigung der Fingerbewegung durch Vergleichen dreier aufeinanderfolgender oder sukzessiver oder fortlaufender detektiert werden kann.

6. Eingabevorrichtung nach einem der vorhergehenden Ansprüche, wobei die Eingabevorrichtung in eine Kochvorrichtung, insbesondere ein vorzugsweise transparentes Glas eines Kochfelds, speziell eines Glaskeramikkochfelds oder eines Induktionskochfelds und/oder eines Backofens und/oder eines Dampfkochtopfs und/oder eines Mikrowellenherds und/oder einer Mikrowellenherd-Kombination und/oder einer freistehenden Kochvorrichtung und/oder einer Kombi-Herdkochplatte integriert ist.

7. Eingabevorrichtung nach einem der vorhergehenden Ansprüche, wobei die Position des Fingers (4) auf einer Anzeige (3) vorzugweise durch einen Cursor (9) angezeigt wird.

8. Verfahren zur Dateneingabe für ein Haushaltsgerät zur Bedingung mit einem Finger (4), insbesondere für eine Eingabevorrichtung nach einem der vorhergehenden Ansprüche,
a) mit sensitiven Tasten (11 - 22), die unter einer Oberfläche in einem zweidimensionalen Feld (2) angeordnet sind,
b) wobei eine Tastenspannung basierend auf der Nähe des Fingers durch jede sensitive Taste (11-22) in Abhängigkeit vom Abstand von der Taste und der Größe des Fingers (4) erzeugt wird,
c) wobei alle erzeugten Tastenspannungen verglichen werden,
d) wobei die Position eines Fingers detektiert wird, und
e) wobei eine Beschleunigung der Fingerbewegung durch Vergleichen detektierter Positionen des Fingers (4) detektiert wird,
**dadurch gekennzeichnet, dass**
die Beschleunigung der Fingerbewegung durch Vergleichen mindestens dreier aufeinanderfolgender oder sukzessiver oder fortlaufender Positionen des Fingers detektiert wird, wobei der Abstand zwischen der ersten und der zweiten Messung mit dem Abstand zwischen der zweiten und der dritten Messung verglichen wird.

9. Verfahren nach Anspruch 8, wobei die Position des Fingers (4) durch Bestimmen der größten Tastenspannung detektiert wird.

10. Verfahren nach Anspruch 8 oder 9, wobei eine Beschleunigung der Fingerbewegung durch Vergleichen dreier, oder mindestens dreier, insbesondere aufeinanderfolgender detektierter Positionen des Fingers (4) detektiert wird.

11. Verfahren nach einem der Ansprüche 8 bis 10, wobei die Detektion nach einer vordefinierten Zeitspanne wiederholt wird.

12. Verfahren nach einem der Ansprüche 8 bis 11, wobei eine Bewegung des Fingers (4) detektiert wird.

## Revendications

1. Dispositif d'entrée (1) d'appareil électroménager destiné à être actionné par un doigt (4), comprenant
a) des touches sensibles (11 - 22) disposées en dessous d'une surface en une matrice bidimensionnelle (2),
b) dans lequel une tension de touche basée sur la proximité du doigt (4) peut être générée par chaque touche sensible (11 - 22) en fonction de la distance par rapport à la touche et de la taille du doigt (4),
c) dans lequel toutes les tensions de touches peuvent être comparées dans une unité de détection (8),
d) dans lequel la position du doigt (4) peut être détectée dans l'unité de détection (8) et
e) dans lequel une accélération du mouvement du doigt peut être détectée en comparant des positions du doigt,
**caractérisé en ce que**
l'accélération du mouvement du doigt peut être détectée en comparant au moins trois positions suivantes ou successives ou subséquentes du doigt, dans lequel la distance entre la première et la deuxième mesure est comparée à la distance entre la deuxième et la troisième mesure.

2. Dispositif d'entrée selon la revendication 1,
a) dans lequel la détection de la position peut être répétée après un laps de temps prédéfini, notamment 100 ms,
et/ou
b) dans lequel un mouvement du doigt (4) peut être détecté, de préférence par rapport à un point de départ fixe et/ou arbitraire.

3. Dispositif d'entrée selon la revendication 1 ou 2, dans lequel les touches sensibles sont au moins sensiblement circulaires.

4. Dispositif d'entrée selon l'une quelconque des revendications précédentes, dans lequel la position du doigt peut être détectée en comparant les tensions de touches générées et déterminant la plus grande tension de touche.

5. Dispositif d'entrée selon l'une quelconque des revendications précédentes, dans lequel une accélération du mouvement du doigt peut être détectée en comparant trois positions du doigt, suivantes ou successives ou subséquentes.

6. Dispositif d'entrée selon l'une quelconque des revendications précédentes, le dispositif d'entrée étant intégré dans un dispositif de cuisson, particulièrement un verre de préférence transparent d'une plaque de cuisson, notamment une plaque vitrocéramique de cuisinière et/ou une plaque à induction et/ou un four de cuisson et/ou un four à vapeur et/ou un four micro-ondes et/ou un ensemble micro-ondes/four combiné et/ou un dispositif de cuisson indépendant et/ou une surface de cuisson de four mixte.

7. Dispositif d'entrée selon l'une quelconque des revendications précédentes, dans lequel la position du doigt (4) est affichée sur un afficheur (3), de préférence par un curseur (9).

8. Procédé d'entrée de données d'appareil électroménager destiné à être actionné par un doigt (4), notamment d'un dispositif d'entrée selon l'une quelconque des revendications précédentes,
a) avec des touches sensibles (11 - 22) disposées en dessous d'une surface en une matrice bidimensionnelle (2),
b) dans lequel une tension de touche basée sur la proximité du doigt est générée par chaque touche sensible (11 - 22) en fonction de la distance par rapport à la touche et de la taille du doigt (4),
c) dans lequel toutes les tensions de touches générées sont comparées,
d) dans lequel la position du doigt est détectée et
e) dans lequel une accélération du mouvement du doigt est détectée en comparant des positions détectées du doigt (4),
**caractérisé en ce que**
l'accélération du mouvement du doigt est détectée en comparant au moins trois positions suivantes ou successives ou subséquentes du doigt, dans lequel la distance entre la première et la deuxième mesure est comparée à la distance entre la deuxième et la troisième mesure.

9. Procédé selon la revendication 8, dans lequel la position du doigt (4) est détectée en déterminant la plus grande tension de touche.

10. Procédé selon la revendication 8 ou 9, dans lequel une accélération du mouvement du doigt est détectée en comparant trois ou au moins trois positions notamment suivantes détectées du doigt (4).

11. Procédé selon l'une des revendications 8 à 10, dans lequel la détection est répétée après un laps de temps prédéfini.

12. Procédé selon l'une des revendications 8 à 11, dans lequel un mouvement du doigt (4) est détecté.
